(19) Europäisches Patentamt
European Patent Office
Office européen des brevets

(11) Publication number: **0 041 949**
**B1**

(12) **EUROPEAN PATENT SPECIFICATION**

(45) Date of publication of patent specification: **10.06.87**

(51) Int. Cl.$^4$: **H 05 K 1/18**

(21) Application number: **80901120.8**

(22) Date of filing: **18.12.79**

(86) International application number:
**PCT/US79/01142**

(87) International publication number:
**WO 81/01784 25.06.81 Gazette 81/15**

# (54) RECESSED CIRCUIT MODULE AND METHOD OF MAKING.

(43) Date of publication of application:
**23.12.81 Bulletin 81/51**

(45) Publication of the grant of the patent:
**10.06.87 Bulletin 87/24**

(84) Designated Contracting States:
**DE FR GB**

(56) References cited:
**DE-A-1 937 638**
**FR-A-1 294 087**
**US-A-2 850 681**
**US-A-3 270 203**
**US-A-3 346 774**
**US-A-3 361 937**
**US-A-3 456 335**
**US-A-3 529 212**
**US-A-3 545 079**
**US-A-3 555 485**
**US-A-3 873 890**

(73) Proprietor: **CTS Corporation**
**905 North West Boulevard**
**Elkhart Indiana 46514 (US)**

(72) Inventor: **STUCKEY, Ronald L.**
**221 West Jackson**
**Monroe, IN 46772 (US)**

(74) Representative: **Amann, Hannes Gerhart et al**
**H.G. Amann and Company 27 Hillersdon Avenue**
**London, SW13 0EG (GB)**

EP 0 041 949 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

Technical Field

The present invention pertains to a circuit module and, more particularly, to a circuit module having conductor films deposited onto a surface of a substrate and having a row of terminals extending from an edge of the substrate.

Background Art

Circuit modules, whether of the single in-line package (SIP) or the dual in-line package (DIP), have typically been of two basic types of construction.

One of the basic types of construction has utilized a thin ceramic substrate upon which an electronic circuit is deposited or attached; and then the substrate with the electronic circuit is encapsulated in a housing. The electronic circuit generally contains thick film and or chip devices, such as resistors and capacitors connected with thick film conductors. A common method of forming the housing has been to mold a thermoset plastic over the substrate. Another method of encapsulating has included using two cover portions and then injecting a potting compound between the cover portions as taught by Fox et al. in U.S. Patent No. 4,012,579. In a similar method, a single cover has been adhesively secured over the substrate and the electrical circuit by use of an adhesive tape as taught by Riley in U.S. Patent No. 3,939,558.

However, with the advent and increasing use of smaller circuit modules, slightly less than 4 mm thick or which can be only 2 mm thick, encapsulated designs have had two serious disadvantages. One of these disadvantages has been relatively weak and insecure attachment of the connector pins both to the housing and to the electrical circuit, thus severely limiting the reliability of the circuit module. The other serious disadvantage has been poor heat dissipation properties and a resultant poor power rating for the molded and potted constructions.

Both the problem of the weak mechanical and electrical attachment of the connector pins and the problem of poor heat dissipation have been solved by constructions taught by Brady et al. in U.S. Patent No. 3,280,378, and by Brady in U.S. Patent No. 3,346,774, both of common assignee. In these designs, a thick ceramic substrate having dimensions almost the same as the housing is used, the connector pins are securely attached to the substrate by force fitting the pins into holes or recesses provided in the substrate, the connector pins are electrically connected to the electrical circuit by soldering, and the electrical circuit is preferably insulated with a nonconductive coating. The resulting module is both mechanically and electrically superior. In addition, the heat dissipation properties of the module are superior and the power rating can be higher because a ceramic substrate has heat conductivity properties that are approximately sixty times as great as a thermosetting plastic used for encapsulating a thin substrate. Also the heat dissipation properties are superior even when the electrical circuit on the thick ceramic substrate is covered by a thin layer of nonconductive material because more than 90% of the volume of the housing defining the module used in the design is ceramic which has excellent heat conductivity.

Circuit modules of the type described above, using a thick ceramic substrate, using a circuit that includes thick film conductors and resistors, and using a thin nonconductive coating, have had one limitation. This limitation has been the inability to attach a separate electrical device, such as a chip capacitor, to the circuit without an excessive increase in the thickness of the circuit module. This disadvantage becomes more severe when the circuit requires the attachment of a capacitor that is almost 1 mm thick.

The present invention eliminates this one disadvantage of the construction which is taught in U.S. Patent Nos. 3,280,378 and 3,346,774, while retaining all of the advantages thereof.

Disclosure of the Invention

In accordance with the invention, there is provided a process for producing a circuit module characterised by the steps of: forming a flat ceramic substrate having a recess along one thin edge face thereof, disposing an electrical device of preselected electrical function within said recess with the electrical device proportioned to be disposed wholly within said recess, connecting by electrical means the electrical device to metallized conductive paths extending along a major face of said substrate and which do not substantially contribute to the stack-up tolerances when a plurality of such substrates are disposed in side-by-side contiguous relationship, and filling the entirety of the unoccupied portion of said recess with an electrically inert plastic material to produce substantially planar side surfaces coplanar with the major faces of the substrate and a top edge surface coplanar with said thin edge face of the substrate, thereby to encapsulate and electrically protect the electrical device which is confined within said plastic material.

Thus, in accordance with the invention, a substrate includes a component-receiving recess in one of the edge surfaces and the component-receiving recess includes a recessed surface. First and second spaced-apart conductor films are deposited onto the recessed surface and are electrically connected to selected ones of the connector pins. A separate electrical device, such as a chip capacitor, is then mechanically and electrically connected to the spaced-apart conductor films by a body of conductive material such as solder.

The advantages of the present invention include compactness, good heat dissipation properties, good mechanical strength between the connector pins and the substrate, good electrical connection between the connector pins and the electrical circuit, the ability to add a separate or discrete electrical device to the circuit without increasing the overall dimensions, e.g., thickness of the module, the ability to utilize dip soldering for connecting the connector pins to the circuit module, secure mechanical attachment of the separate electrical device to the circuit module such as by soldering of the separate electrical device to the spaced-apart conductor films, and good electrical connection of the separate electrical device to the electrical circuit of the circuit module by the aforementioned solder connection.

Further advantages of the present invention will become apparent as the following description proceeds, and the features of novelty characterizing the invention will be pointed out with particularity in the claims annexed to and forming a part of this specification.

For a better understanding of the present invention, reference may be had to the accompanying drawings and detailed description wherein the same reference numerals have been applied to like parts.

Brief Description of the Drawings

FIGURE 1 is a perspective view of the circuit module with a nonconductive coating and showing the connector pins thereof extending toward the viewer;

FIGURE 2 is a schematic drawing of the electrical circuit of the circuit module of Fig. 1;

FIGURE 3 is a slightly enlarged rear view of the module of Fig. 1 with the nonconductive coating and showing a discrete electrical device supported in a notch;

FIGURE 4 is a side view of the circuit module of Fig. 3;

FIGURE 5 is a front view of the circuit module of Figs. 3 and 4 showing the discrete electrical device supported in the notch and film resistors supported on a surface of the module, both the device and the resistors being connected to the connector pins;

FIGURE 6 is an enlarged fragmentary view of the circuit module of Fig. 5; and

FIGURE 7 is a front view of an additional embodiment of a circuit module.

Best Mode for Carrying Out the Invention

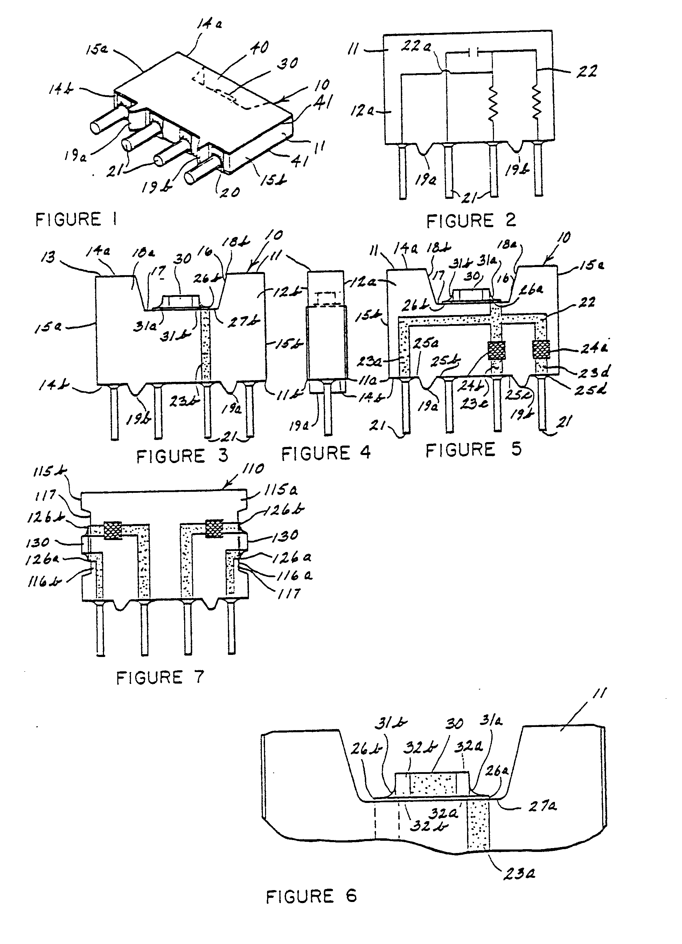

Referring now to the drawings, and more particularly to Figs. 1 and 3—5, a circuit module 10 includes a ceramic substrate 11 of dielectric material, e.g., alumina or steatite, having spaced-apart major side surfaces 12a, 12b having edge surface means 13 that includes spaced-apart edge surfaces 14a, 14b and that includes spaced-apart edge surfaces 15a, 15b. The substrate 11 includes a component-receiving recess 16 interrupting the edge surface 14a that includes an additional edge surface means 13 defined by a recessed surface 17 and defines a pair of ears 18a, 18b extending outwardly from the recessed surface 17. The substrate 11 also includes a pair of stand-offs 19a, 19b extending outwardly from the edge surface 14b.

Specifically referring to the substrate 11, it includes a plurality of pin-receiving recesses or openings 20 preferably square in cross-section. A plurality of connector pins 21 are force fitted into respective ones of the pin-receiving recesses 20, the connector pins 21 preferably being of cylindrical shape; and the force fitting of the connector pins 21 into the pin-receiving recesses 20 preferably comprises interference between the cylindrical shape of the connector pins 21 and the square cross-sectional shape of the pin-receiving recesses 20.

As shown in Fig. 5, an electrical circuit 22 is deposited onto the side surface 12 of the substrate 11. The electrical circuit 22 includes deposited conductor films 23a, 23c, and 23d; and the electrical circuit 22 further includes deposited resistor films 24a and 24b respectively overlapping and electrically connecting the deposited conductor films 23a and the deposited conductor films 23c, 23d. The circuit module 10 further includes deposited conductor pads 25a, 25b, 25c, and 25d deposited upon the edge surface 14b. The deposited conductor pads 25a, 25c, and 25d are electrically connected to the deposited conductor films 23a, 23c, and 23d respectively by overlapping of the respective conductor films at a corner 11a of the substrate 11. In like manner, a deposited conductor film 23b on the side surface 12b is electrically connected to the deposited conductor pad 25b by overlapping the deposited conductor pad 25b at a corner 11b of the substrate 11.

The connector pins 21 are both mechanically and electrically connected to respective ones of the conductor pads 25a, 25b, 25c, and 25d by dipping the connector pins 21 and the edge surface 14b in a molten solder. Referring now to Fig. 4, a side view of the circuit module 10 is shown having the thickness of both the conductor films 23a, 23b, 23c, and 23d and the resistor films 24a and 24b slightly enlarged to illustrate that the conductor and resistor films are deposited on the substrate 11.

Referring now to Figs. 3, 5 and 6, the circuit module 10 further includes a pair of spaced-apart metallic conductors or spaced-apart conductor films 26a, 26b which are preferably formed by depositing the films onto the recessed surface 17. The conductor film 26a is electrically connected to the conductor film 23a (see Figs. 5 and 6) by overlapping the films 26a, 23a at a corner 27a of the substrate 11. In like manner, the conductor film 26b is electrically connected to the conductor film 23b by overlapping the films 26b, 23b at a corner 27b.

An electrical device 30, which may be either an integrated circuit chip that includes a plurality of active and/or inactive components or which may be a single function component that is either active or passive, is attached to the conductor films 26a, 26b by a body of conductive material such as solder or solder connections 31a, 31b as best shown in Fig. 6. In a preferred configuration, the electrical device 30 comprises a capacitor but, in other embodiments, the electrical device 30 may comprise an active component such as a diode or transistor or a passive component such as a resistor having conductive metallic ends 32a, 32b. The solder connections 31a, 31b may be effected by heating preforms or by separately soldering these two connections.

Referring now to Figs. 3, 5 and 6, the circuitry thus far described is schematically shown in Fig. 2. As can be seen in Fig. 2, by a crossover of connectors at a location 22a, it is advantageous to deposit the conductor film 23b on the side surface 12b as shown. Thus, the embodiment illustrated utilizes both of the side surfaces, 12a, 12b. However, in many embodiments conductor films are only deposited on one of the side surfaces, 12a or 12b.

In an additional embodiment, a circuit module 110 (see Fig. 7) includes like-numbered and like-named parts as have been previously described, except that the recesses 116a, 116b having recessed surfaces 117 are located at opposite end surfaces 115a, 115b. The conductor films 126a, 126b have been applied to each of the recessed surfaces 117 and electrical devices 130 are soldered to the films 126a, 126b.

Referring now to Fig. 1, a nonconductive material 40 such as epoxy has been used to fill the component-receiving recess 16 thereby providing insulation for the conductor films 26a, 26b and the electrical device 30 and also concealing the device 30. A layer of nonconductive material or coating 41 has been applied to the surfaces 12a, 12b of the substrate 11, thereby covering both of the side surfaces 12a, 12b and the electrical circuit 22. It should be noticed that the edge surfaces 14a, 14b, 15a, 15b in the preferred embodiment as shown in Fig. 1 are not covered, thereby leaving these surfaces on the substrate 11 exposed for maximum heat dissipation and for a maximum power rating for the circuit module 10.

The preferred method includes depositing the conductor films 23a, 23b, 23c, 23d, depositiong the conductor pads 25a, 25b, 25c, 25d, and depositing the conductor films 26a, 26b on the surfaces of the substrate 11 and firing the substrate with the films and pads. The resistor films 24a, 24b are then deposited on the substrate, and the substrate with resistor films 24a, 24b is fired. The connector pins 21 are then forced into the pin-receiving recesses 20, the connector pins 21 are soldered to respective ones of the conductor pads 25a, 25b, 25c, 25d, connecting the metallic ends 32a, 32b to respective ones of the conductor films 26a, 26b. The recess 16 is then filled with the nonconductive material 40. The surfaces 12a, 12b are then covered with the layer of nonconductive material 41 which preferably has a thickness of .025 to .05 mm and preferably comprises an epoxy.

In summary, the surfaces 14a, 14b, 15a, 15b and 17 provide the edge surface means 13 for interconnecting the side surfaces 12a, 12b. By disposing the electrical device 30 on the recessed surfaces 17 and within the planar bounds of the side surfaces 12a, 12b, minimum thickness for the completed circuit module 10 is maintained.

The dielectric substrate 11 may be 96% to 98% of the total thickness of the circuit module 10 because of the small thickness of both the electrical circuit 22 and the coating 41. Thus the circuit module 10 has excellent heat dissipation and power capacity ratings for a given size. In addition, the circuit module 10 of the present invention provides added circuit flexibility by being able to accept additional electrical devices, such as the electrical device 30, without increasing the overall thickness of the circuit module 10 and without appreciably reducing the heat dissipation capacity and power rating thereof.

Industrial Applicability

The present invention is industrially applicable to complex electrical circuits, such as digital computers, where a plurality of microminiature circuit modules are to be installed in a limited space.

**Claims**

1. A process for producing a circuit module (10) characterised by the steps of: forming a flat ceramic substrate (11) having a recess (16) along one thin edge face (14a) thereof, disposing an electrical device (30) of preselected electrical function within said recess (16) with the electrical device proportioned to be disposed wholly within said recess, connecting by electrical means the electrical device to metallized conductive paths (23) extending along a major face (12a) of said substrate and which do not substantially contribute to the stack-up tolerances when a plurality of such substrates are disposed in side-by-side contiguous relationship, and filling the entirety of the unoccupied portion of said recess (16) with an electrically insulating plastics material to produce substantially planar side surfaces coplanar with the major faces (12) of the substrate and a top edge surface coplanar with said thin edge face (14a) of the substrate, thereby to encapsulate and electrically protect the electrical device (30) which is confined within said plastics material.

2. The process of producing a circuit module in accordance with Claim 1, wherein the electrical device is mounted within said recess through a combination mechanical-and-electrical means connecting the metallized paths (23) to said electrical device (30).

3. The process in accordance with Claim 1, further comprising the step of forming another recess along the thin edge face and disposing another electrical device therein.

4. The process in accordance with Claim 1, including the step of forming a substrate having only minimal sized pin receiving openings (20) and device receiving recesses (16) in order to preserve the essential heat dissipating properties of the ceramic substrate.

5. A process for producing a circuit module assembly comprising circuit modules produced according to Claim 1, and adapted for use in limited space surroundings, comprising the steps of disposing contiguous said circuit modules (10) with the corresponding major faces abutting each other.

6. The process in accordance with Claim 5, including the step of forming metallized conductive paths along selected faces of each substrate without contributing substantially to stack-up dimensions whereby the cumulative dimension of the total stack is substantially equal to the combined widths of said substrates.

7. The process in accordance with Claim 6, including the steps of securing to an edge surface (14b) a plurality of connector pins (21) for selective interconnection through said metallized paths (23) with the electrical device (30).

8. The process in accordance with Claim 7, including the step of force fitting the connector pins (21) into openings (20) at the edge surface.

9. The process in accordance with Claim 8, including the step of forming complementary openings along said edge surface of said substrate and force-fitting non-conforming cross-sectional shaped connector pins into such complementary openings for permanent disposal therein.

10. A circuit module of the type having a ceramic substrate (11) which includes first and second spaced apart side surfaces (12a, 12b) and a plurality of edge (14, 15) surfaces interconnecting the side surfaces, having a plurality of connector pins (21) that are disposed substantially parallel to the side surfaces and that extend outwardly from the substrate, and sized to permit a plurality of equally sized circuit modules to be positoned side-by-side with a cumulative stack-up dimension corresponding substantially to the cumulative widths of the positioned modules; characterised by a component-receiving recess (16) in at least one of the edge surfaces including a recess surface and which does not compromise the width of the substrate, first and second spaced apart conductive films (26a, 16) deposited onto the recess surface and operatively connected to selected ones of the connector pins (21), an electrical device (30) of selected electrical functions and proportioned to be disposed wholly within the first and second spaced apart side surfaces (12a, 12b) and said recess (16), combination mechanical-and-electrical means (31a, 31b) connecting the spaced-apart conductor films (26a, 26b) to the electrical device, and a plastics filler (40) substantially filling the entirety of said recess (16) and encapsulating the electrical device without contributing any dimensional increase to the stack-up tolerances of the side-by-side contiguous circuit modules.

11. The circuit module of Claim 10, wherein the mechanical and electrical means (31a, 31b) connecting the electrical device to the conductor films (26a, 26b) comprises a body of metal.

12. The circuit module of Claim 10, wherein a second electrical circuit is deposited on the other one of the side surfaces and is operatively connected to selected ones of said connector pins.

13. The circuit module of Claim 10, wherein the electrical device comprises a capacitor.

14. The circuit module of Claim 10, wherein the edge surfaces include first (14b) and second (14a) edge surfaces that are spaced apart, and third (15a) and fourth (15b) edge surfaces that are spaced apart and that interconnect the first and second edge surfaces, the connector pins (21) extend outwardly from the first edge surface (14b), and the component-receiving recess disposed in the second edge surface (14a).

**Patentansprüche**

1. Verfahren zur Herstellung eines Schaltkreismoduls (10) gekennzeichnet durch die Schritte: Formen eines flachen keramischen Trägers (11) mit einer Vertiefung (16) längs einer seiner schmalen Stirnflächen (14a), Anbringen einer elektrischen Einrichtung (30) mit vorgegebener elektrischer Funktion innerhalb der Vertiefung (16), wobei die elektrische Einrichtung so proportioniert ist, daß sie vollständig innerhalb der Vertiefung anbringbar ist, Herstellen einer elektrischen Verbindung der elektrischen Einrichtung mit metallisierten Leiterbahnen (23), welche sich längs einer Hauptfläche (12a) des Trägers erstrekken und welche nicht wesentlich beitragen zu den Stapeltoleranzen, wenn eine Mehrzahl derartiger Träger seitlich benachbart angeordnet werden, und Auffüllen des gesamten nicht besetzten Bereiches der Vertiefung (16) mit einem elektrisch isolierenden Kunststoffmaterial, um im wesentlichen ebene mit den Hauptflächen (12) des Trägers coplanare seitliche Oberflächen und eine mit der schmalen Stirnfläche (14a) des Trägers coplanare obere Stirnfläche herzustellen, so daß die vom Kunststoffmaterial umgebene elektrische Einrichtung (30) eingekapselt und elektrisch geschützt wird.

2. Verfahren zur Herstellung eines Schaltkreismoduls nach Anspruch 1, wobei die elektrische Einrichtung innerhalb der Vertiefung durch eine kombinierte mechanische und elektrische Einrichtung angebracht ist, welche die metallischen Leiterbahnen (23) mit der elektrischen Einrichtung (30) verbindet.

3. Verfahren nach Anspruch 1, weiter enthaltend den Schritt, daß eine weitere Vertiefung längs der schmalen Stirnseite geformt und darin eine weitere elektrische Einrichtung angebracht wird.

4. Verfahren nach Anspruch 1, enthaltend den Schritt, daß ein Träger geformt wird, welcher Stiftaufnahemöffnungen (20) und Einrichtungsaufnahmevertiefungen (16) mit nur minimaler Größe aufweist, um die wesentlichen Eigenschaften des keramischen Trägers für die Wärmeabführung zu erhalten.

5. Verfahren zur Herstellung einer Schaltkreismodulbaugruppe mit nach Anspruch 1 hergestellten Schaltkreismodulen und geeignet für die Verwendung in einer Umgebung mit begrenztem Raum, enthaltend die Schritte, daß die Schaltkreismodule (10) mit den korrespondierenden Hauptflächen aneinander anstoßend benachbart angeordnet werden.

6. Verfahren nach Anspruch 5, enthaltend den Schritt, daß metallisierte Leiterbahnen längs ausgewalter Flächen auf jedem Träger gebildet werden, ohne zu den Stapeldimensionen wesentlich beizutragen, wodurch die Gesamtdimension des vollständigen Stapels im wesentlichen gleich ist den kombinierten Breiten der Träger.

7. Verfahren nach Anspruch 6, enthaltend die Schritte, daß an einer Stirnfläche (14b) eine Mehrzahl von Anschlußstiften (21) zur wahlweisen Verbindung über die metallisierten Bahnen (23) mit der elektrischen Einrichtung (30) angebracht werden.

8. Verfahren nach Anspruch 7, enthaltend den Schritte, daß die Anschlußstifte (21) in die öffnungen (20) an der Stirnfläche unter Druck eingesetzt werden.

9. Verfahren nach Anspruch 8, enthaltend den Schritt, daß längs der Stirnfläche des Trägers komplementäre öffnungen eingeformt und bezüglich ihres Querschnitts nicht übereinstimmende Anschlußstifte in derartige komplementäre öffnungen zur permanenten Anbringung darin unter Druck eingesetzt werden.

10. Schaltkreismodul der Art, welche einen keramischen Träger (11) aufweist, der erste und zweite, voneinander beabstandete Seitenflächen (12a, 12b) und mehrere die Seitenflächen verbindende Stirnflächen (14, 15) enthält, mit mehreren Anschlußstiften (21), welche im wesentlichen parallel zu den Seitenflächen angebracht sind und sich vom Träger nach außen erstrecken, und mit einer solchen Größe, daß es ermöglicht ist, mehrere Schaltkreismodule gleicher Größe Seite an Seite anzuordnen mit einer gesamten Stapeldimension, die im wesentlichen den zusammengefaßten Breiten der angeordneten Modulen enspricht, dadurch gekennzeichnet, daß eine eine Komponente aufnehmende Vertiefung (16) in zumindest einer der Stirnflächen eine vertiefte Oberfläche aufweist und, wodurch die Breite des Trägers nicht beeinträchtigt wird, erste und zweite voneinander beabstandete leitfähige Filme (26a, 16b), welche auf die Oberfläche der Vertiefung aufgebracht und wirkungsmäßig mit ausgewählten der Anschlußstifte (21) verbunden sind, eine elektrische Einrichtung (30) mit gegebenen elektrischen Funktionen und solchen Proportionen, daß sie vollständig zwischen der ersten und der zweiten voneinander beabstandeten Seitenfläche (12a, 12b) und innerhalb der Vertiefung (16) anbringbar ist, eine kombinierte mechanische und elektrische Einrichtung (31a, 31b), welche die voneinander beabstandeten leitfähigen Filme (26a, 26b) mit der elektrischen Einrichtung verbinden, und ein Kunststoff-Füllmaterial (40), welches im wesentlichen die Vertiefung (16) vollständig auffüllt, und die elektrische Einrichtung einkapselt, ohne zu einem Größenzuwachs der Stapel-Toleranzen der Seite an Seite aneinander anstoßenden Schaltkreismodule zu führen.

11. Schaltkreismodul nach Anspruch 10, wobei die mechanische und elektrische Einrichtung (31a, 31b), welche die elektrische Einrichtung mit den leitfähigen Filmen (26a, 26b) verbindet, einen Körper aus Metall enthält.

12. Schaltkreismodul nach Anspruch 10, wobei ein zweiter elektrischer Schaltkreis auf der anderen der Seitenflächen angebracht ist und funktionell mit ausgewählten Anschlußstiften verbunden ist.

13. Schaltkreismodul nach Anspruch 10, wobei die elektrische Einrichtung einen Kondensator enthält.

14. Schaltkreismodul nach Anspruch 10, wobei die Stirnflächen erste (14b) und zweite (14a) voneinander beabstandete Stirnflächen enthalten, sowie dritte (15a) und vierte (15b) Stirnflächen, welche voneinander beabstandet sind, und welche die ersten und zweiten Stirnflächen miteinander verbinden, wobei sich die Anschlußstifte (21) von der ersten Stirnfläche (14b) nach außen erstrecken und die die Komponente aufnehmende Vertiefung in der zweiten Stirnfläche (14a) angebracht ist.

**Revendications**

1. Procédé pour fabriquer un module de commutation (10) caractérisé par les étapes de: formation d'un substrat en céramique plat (11) ayant un évidement (16) le long d'une face de bord mince (14a) de celui-ci, mise en place d'un dispositif électrique (30) de fonction électrique présélectionnée à l'intérieur dudit évidement (16), le dispositif électrique étant proportionné pour être placé entièrement à l'intérieur dudit évidement, connexion par des moyens électriques du dispositif électrique à des chemins conducteurs métallisés (23) s'étendant le long d'une face principale (12a) dudit substrat et qui ne contribuent pas sensiblement aux tolérances d'empilement quand un ensemble de tels substrats sont disposés en rapport contigu l'un à côté de l'autre, et de remplissage de la totalité de la portion inoccupée dudit évidement (16) avec une matière plastique électriquement isolante pour produire des surfaces latérales sensiblement planes coplanaires par rapport aux faces principales (12) du substrat et une surface de bord supérieur coplanaire par rapport à ladite face de bord mince (14a) du substrat, afin, de cette manière, d'enrober et de protéger électriquement le dispositif électrique (30) qui est renfermé à l'intérieure de ladite matière plastique.

2. Procédé de fabrication d'un module de commutation selon la revendication 1, dans lequel le dispositif électrique est monté à l'intérieur dudit évidement par des moyens électriques et mécaniques de combinaison connectant les chemins conducteurs métallisés (23) audit dispositif électrique (30).

3. Procédé selon la revendication 1, comprenant en outre l'étape de formation d'un autre évidement le long de la face de bord mince et de mise en place d'un autre dispositif électrique à l'intérieur.

4. Procédé selon la revendication 1, comprenant l'étape de formation d'un substrat présentant des ouvertures (20) pour recevoir des broches de taille minimum uniquement et des évidements (16) pour recevoir le dispositif afin de préserver les propriétés essentielles de rayonnement de chaleur du substrat en céramique.

5. Procédé pour fabriquer un assemblage de modules de commutation comprenant des modules de commutation fabriqués selon la revendication 1, et adaptés pour être utilisés dans un espace limité, comprenant les étapes de mise en place desdits modules de commutation (10) contigus avec les surfaces principales correspondantes aboutant l'une à l'autre.

6. Procédé selon la revendication 5, comprenant l'étape de formation de chemins conducteurs métallisés le long de faces sélectionnées de chaque substrat sans contribuer sensiblement à empiler les dimensions de sorte que la dimension cumulative de l'empilage total est sensiblement égale aux largeurs combinées desdits substrats.

7. Procédé selon la revendication 6, comprenant les étapes de fixation à une surface de bord (14b) d'un ensemble de broches de raccordement (21) pour une interconnexion sélective par lesdits chemins métallisés (23) avec le dispositif électrique (30).

8. Procédé selon la revendication 7, comprenant l'étape d'insertion par force des broches de raccordement (21) dans des ouvertures (20) dans la surface de bord.

9. Procédé selon la revendication 8, comprenant l'étape de formation d'ouvertures complémentaires le long de ladite surface de bord dudit substrat et d'insertion par force de broches de raccordement formées de manière non-conforme en coupe transversale dans ces ouvertures complémentaires pour être placées de façon permanente en-dedans.

10. Module de commutation du type ayant un substrat en céramique (11) qui comprend des première et seconde surfaces latérales espacées (12a, 12b) et un ensemble de surfaces de bord (14, 15) reliant entre elles les surfaces latérales, ayant une ensemble de broches de raccordement (21) qui sont placées de manière sensiblement parallèle aux surfaces latérales et qui s'étendent à l'extérieur du substrat, et calibrées pour permettre à un ensemble de modules de commutation pareillement calibrés d'être mis en place l'un à côté de l'autre avec une dimension cumulative d'empilage correspondant sensiblement aux largeurs cumulatives des modules mis en place; caractérisé par un évidement pour recevoir le composant (16) dans au moins une des surfaces de bord comprenant une surface à évidement et qui ne compromet pas la largeur du substrat, des premier et second films conducteurs espacés (26a, 16b) déposés sur la surface à évidement et reliés de manière active à certaines broches de raccordement (21) sélectionnées, un dispositif électrique (30) à fonctions électriques sélectionnées et proportionné pour être placé entièrement à l'intérieur des première et seconde surfaces latérales espacées (12a, 12b) et dudit évidement (16), des moyens électriques et mécaniques de combinaison (31a, 31b) connectant les films conducteurs espacées (26a, 26b) au dispositif électrique, et une matière de remplissage en plastique (40) remplissant sensiblement la totalité dudit évidement (16) et enrobant le dispositif électrique sans apporter aucune augmentation dimensionnelle aux tolérances d'empilage des modules de commutation contigus côte à côte.

11. Module de commutation de la revendication 10, dans lequel les moyens électriques et mécaniques (31a, 31b) connectant le dispositif électrique aux films conducteurs (26a, 26b) comprennent un corps en métal.

12. Module de commutation de la revendication 10, dans lequel un second circuit électrique est déposé sur l'autre surface latérale et est relié de manière active à certaines broches de raccordement sélectionnées.

13. Module de commutation de la revendication 10, dans lequel le dispositif électrique comprend un condensateur.

14. Module de commutation de la revendication 10, dans lequel les surfaces de bord comprennent des première (14b) et seconde (14a) surfaces de bord qui sont espacées, et des troisième (15a) et quatrième (15b) surfaces de bord qui sont espacées et qui relient entre elles les première et seconde surfaces de bord, les broches de raccordement (21) s'étendant en dehors de la première surface de bord (14b), et l'évidement destiné à recevoir le composant étant placé dans la second surface de bord (14a).

14a
15a
40
30
10
14b
41
11
41
19a
21
19b
20
15b
11
22a
22
12a
19a
21
19b
13
14a
18a
30
16
18b
10
11
17
26b
12b
15a
31a
31b
27b
15b
14b
19b
23b
19a
21
11b
11
12a
11a
14b
19a
11
14a
18b
31b
31a
18a
10
15a
30
17
16
26a
26b
22
15b
25a
24a
23a
25b
24b
23d
23c
25c
25d
19a
19b
21
21
115b
110
117
115a
126b
126b
130
130
126a
126a
116b
116a
117
11
31b
30
31a
26b
32b
32a
26a
27a
32a
32b
23a

FIGURE 1

FIGURE 2

FIGURE 3

FIGURE 4

FIGURE 5

FIGURE 7

FIGURE 6